# FASCICULE DE BREVET EUROPEEN

(11) **EP 0 465 314 B1**
(45) Date de publication et mention de la délivrance du brevet: **13.10.1993**
(21) Numéro de dépôt: 91401756.1
(22) Date de dépôt: 27.06.1991
(51) Int. Cl.: H03B 19/14

(54) **Amplificateur à sortie en double bande**
Verstärker mit Doppelbandausgang
Amplifier with dual band output

(30) Priorité: 04.07.1990 FR 9008476
(43) Date de publication de la demande: 08.01.1992
(73) Titulaire: MATRA COMMUNICATION, 29101 Quimper Cédex (FR)
(72) Inventeur: Jolivet, André, F-78000 Versailles (FR)
(74) Mandataire: Fruchard, Guy

(56) Documents cités:
- EP-A- 0 085 241
- ELECTRONICS, vol. 47, no. 12, 13 juin 1974, page 106; M.F. BLACK: "Switched frequency doubler provides multiple outputs"
- HEWLETT-PACKARD JOURNAL, vol. 32, no. 2, février 1981, pages 22-26, Amstelveen, NL; D.L. PLATT et al.: "A high-purity signal generator output section"
- IEEE MTT-S INTERNATIONAL MICROWAVE SYMPOSIUM DIGEST, Long Beach, California, 13-15 juin 1989, vol. 1, pages 1291-1294, IEEE, New York, US; Y. IYAMA et al.: "Second-harmonic reflector type high-gain FET frequency doubler operating in K-band"

## Description

La présente invention concerne un amplificateur à sortie en double bande de fréquence et plus particulièrement un amplificateur qui, à partir d'un signal d'entrée à une fréquence donnée, fournit un signal de sortie non seulement amplifié mais également modulé à une fréquence égale ou double de la fréquence du signal d'entrée.

On connaît des amplificateurs doubleurs comportant un transistor associé à un circuit d'adaptation d'impédance d'entrée, un circuit de polarisation, un circuit d'adaptation de sortie et un circuit de dérivation relié à la masse et adapté à engendrer un doublement de fréquence d'un signal d'entrée.

Le document Electronics, vol.47 no. 12, 13 juin 1974, p.106, M.F. BLACK "Switched frequency doublers provides multiple outputs" donne également un exemple d'amplificateur doubleur.

Par ailleurs, on sait qu'en raison de l'augmentation constante du nombre d'utilisateurs des réseaux de radio téléphonie, les bandes de fréquences affectées à la comunication radio de ces réseaux sont maintenant saturées ou proches de la saturation et il est donc nécessaire de prévoir de nouvelles bandes de fréquences afin d'accueillir un nombre plus grand d'utilisateurs. Toutefois, l'ouverture de nouvelles bandes de fréquences pose le problème d'une compatibilité de fonctionnement d'un réseau sur les deux bandes de fréquences. En particulier, il est nécessaire de prévoir que des utilisateurs puissent communiquer sur l'une ou l'autre des deux bandes de fréquences sans avoir à disposer de deux organes de radio communication distincts. A ce propos, il est envisagé d'affecter à un réseau une nouvelle bande de fréquences centrée sur une fréquence sensiblement égale au double de la fréquence centrale de la bande de fréquences existante.

La présente invention concerne donc un amplificateur adapté à effectuer une amplification d'un signal à une fréquence donnée et à délivrer un signal amplifié à cette fréquence, ou à une fréquence double de la fréquence d'entrée.

Selon l'invention telle que définie dans la revendication, on prévoit un amplificateur doubleur du type décrit ci-dessus, dans lequel un organe de commutation entre un état ouvert ou fermé est inséré entre le circuit de dérivation et la masse.

Ainsi, lorsque l'organe de commutation est dans un état fermé, le circuit de dérivation remplit sa fonction et l'amplificateur délivre un signal de sortie amplifié à une fréquence double du signal d'entrée tandis que pour un état ouvert de l'organe de commutation, le circuit de dérivation est mis hors service et l'amplificateur délivre un signal de sortie amplifié à une fréquence égale à celle du signal d'entrée.

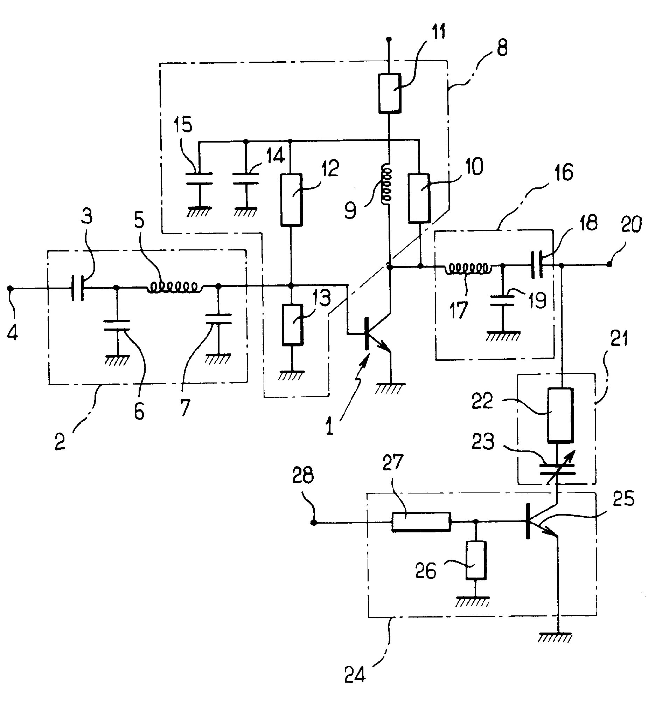

D'autres caractéristiques et avantages de l'invention ressortiront à la lecture de la description qui suit d'un mode de réalisation particulier non limitatif de l'invention en liaison avec la figure unique ci-jointe qui est une représentation schématique d'un amplificateur selon l'invention.

En référence à la figure, l'amplificateur selon l'invention comporte un transistor 1 associé de façon habituelle à un circuit d'adaptation d'impédance d'entrée généralement désigné en 2 et comportant un condensateur de découplage 3 relié à la borne d'entrée 4 de l'amplificateur, une impédance inductive 5 en série avec le condensateur 3 et deux condensateurs 6 et 7 montés en dérivation aux bornes de l'impédance inductive 5.

Par ailleurs, l'amplificateur comporte un circuit de polarisation généralement désigné en 8 et comprenant également de façon habituelle une impédance inductive 9 associée à des résistances de polarisation 10, 11, 12 et 13 et des condensateurs 14 et 15.

L'amplificateur comporte en outre un circuit d'adaptation de circuit généralement désigné en 16 et comportant une impédance inductive 17 associée à un condensateur 18 monté en série et un condensateur 19 monté en dérivation.

Immédiatement en amont de la sortie 20 de l'amplificateur, celui-ci comporte un circuit de dérivation doubleur de fréquence généralement désigné en 21 et comportant une charge inductive 22 et un condensateur d'adaptation 23.

Le circuit de dérivation doubleur de fréquence 21 est relié à la masse par l'intermédiaire d'un organe de commutation généralement désigné en 24. Dans le mode de réalisation illustré, l'organe de commutation comporte un transistor 25 ayant ses bornes de puissance respectivement reliées au condensateur 23 et à la masse et sa borne de commande reliée par des résistances de polarisation 26 et 27 à une entrée de commande 28 de l'organe de commutation.

Selon le signal de commande qui est fourni à la borne d'entrée 28, le transistor 25 se trouve dans un état bloqué ou passant et l'amplificateur selon l'invention délivre un signal amplifié à une fréquence respectivement égale ou double de la fréquence du signal appliqué à la borne d'entrée 4.

Bien entendu l'invention n 'est pas limitée au mode de réalisation décrit et l'on peut y apporter des variantes de réalisation sans sortir du cadre de l'invention. En particulier, l'organe de commutation peut être un interrupteur mécanique ou électro-mécanique et les circuits d'adaptation d'impédance et de polarisation peuvent être modifiés en fonction de l'installation dans laquelle l'amplificateur selon l'invention est intégré.

## Revendications

1. Amplificateur doubleur comportant un transistor (1) associé à un circuit d'adaptation d'impédance d'entrée (2), un circuit de polarisation (8), un circuit d'adaptation de sortie (16), et un circuit de dérivation (21) adapté à engendrer un doublement de fréquence d'un signal d'entrée lorsqu'il est relié à la masse, caractérisé en ce qu'il comporte un organe de commutation (24) entre un état ouvert ou fermé disposé entre le circuit de dérivation et la masse.

## Patentansprüche

1. Verstärker mit Frequenzverdopplung, umfassend einen mit einer Anpassungschaltung (2) zur Anpassung der Eingangsimpedanz verbundenen Transistor (1), eine Basisspannungsschaltung (8), eine Ausgangsanpassungschaltung (16) und eine Nebenschlußschaltung (21), die eine Verdopplung der Frequenz eines Eingangssignales bewirken kann, wenn sie mit der Masse verbunden ist, dadurch **ge****kennzeichnet,** daß er einen Schalter (24) zum Umschalten zwischen einem Öffnungs- oder Schließzustand umfaßt, der zwischen der Nebenschlußschaltung und der Masse angeordnet ist.

## Claims

1. A doubler amplifier comprising a transistor (1) associated with an input impedance matching circuit (2), a biasing circuit (8), an output matching circuit (16), and a branching circuit (21) adapted to produce frequency doubling of an input signal when it is connected to earth, characterised in that it comprises a switching member (24) for switching between an open or a closed state, which is disposed between the branching circuit and earth.
